Europäisches Patentamt

European Patent Office

Office européen des brevets

(19)

(11) Publication number: **0 141 467**
**B1**

(12) **EUROPEAN PATENT SPECIFICATION**

(45) Date of publication of patent specification: **27.01.88**

(21) Application number: **84201566.1**

(22) Date of filing: **31.10.84**

(51) Int. Cl.⁴: **H 05 K 13/04**

(54) **Device for applying a fixing medium to electronic components, more particularly to chip-type components.**

(30) Priority: **04.11.83 NL 8303797**

(43) Date of publication of application:
**15.05.85 Bulletin 85/20**

(45) Publication of the grant of the patent:
**27.01.88 Bulletin 88/04**

(84) Designated Contracting States:
**AT BE CH DE FR GB IT LI NL SE**

(56) References cited:
**EP-A-0 071 303**

(73) Proprietor: **N.V. Philips' Gloeilampenfabrieken**
**Groenewoudseweg 1**
**NL-5621 BA Eindhoven (NL)**

(72) Inventor: **van Gastel, Josephus Martinus Maria**
**c/o INT. OCTROOIBUREAU B.V. Prof. Holstlaan 6**
**NL-5656 AA Eindhoven (NL)**
Inventor: **van Nunen, Hendrikus Theodorus**
**c/o INT. OCTROOIBUREAU B.V. Prof. Holstlaan 6**
**NL-5656 AA Eindhoven (NL)**
Inventor: **Sanders, Leonardus Cornelis Maria**
**c/o INT. OCTROOIBUREAU B.V. Prof. Holstlaan 6**
**NL-5656 AA Eindhoven (NL)**

(74) Representative: **Hartung, Edgar Erwin et al**
**INTERNATIONAAL OCTROOIBUREAU B.V. Prof.**
**Holstlaan 6**
**NL-5656 AA Eindhoven (NL)**

EP 0 141 467 B1

Courier Press, Leamington Spa, England.

## Description

The invention relates to a device for applying a fixing medium to electronic components, more particularly to chip-type components, comprising a trough for containing fixing medium and a plurality of stamps with stamp heads which are directed vertically upwards and which stamps are arranged in a regular geometric pattern, the stamps being coupled at their lower ends to a common driving element and each being displaceable in a vertical direction between a lower rest position in which the respective stamp head is situated wholly within the trough and an upper working position in which the stamp head projects above the trough.

Such a device is known from European Patent EP—A—0 071 303. This known device serves to apply glue simultaneously to the lower sides of a plurality of electronic chip-type components which have been temporarily halted over a container containing a fixing medium and which are positioned with respect to the stamps. In this known device, all the stamps are identical, are rigidly secured to a driving rod and have a stamp head of the same shape.

The range of chip-type electronic components which do not have the conventional comparatively long connection wires and which can be mounted on imperforate substrates is gradually becoming wider. An increasing number of types and kinds of components are adapted for so called surface mounting on imperforate substrates. The variety of chip-type components, both with regard to type and with regard to shape and dimensions, still increases. As to the dimensions of the components to be processed, dimensions are to be considered which lie in the millimeter range; a frequency occuring type has the dimensions of $0.8 \times 1.6 \times 3.2$ mm. As to their shape, the chip-type components can also differ greatly. The most frequently occuring components are block- or plate-shaped. However, cylindrical components are also known.

As is known and as has been described in the aforementioned European Patent Application EP—A—0 071 303, these components are fixed temporarily by means of a fixing medium on the substrate before they are ultimately soldered on the substrate. For this purpose, a quantity of fixing medium is applied to the lower sides of the chip-type components by means of the device known from the said European Patent Application. It has now been found that specific requirements apply to every kind of chip-type component as to the shape and the volume of the applied quantity of fixing medium. It has been found in practice that, in order to obtain a reliable adhesion of the component to the substrate, without the track pattern on the substrate being contaminated with the fixing medium, for every kind of chip-type component a given optimum quantity of fixing medium is necessary, which has to be applied to the component in a given form. These requirements cannot be satisfied when the said known device is used.

The present invention has for its object to provide a device by means of which it is possible to apply to various electronic components, more particularly chip-type components, simultaneously and in a reproducible manner, a fixing medium in a metered quantity and in a given form which are optimal and specific for each type and kind, which device moreover can be adapted in a simple manner to a variety of components to be processed.

According to the invention, this object is mainly achieved in that the stamps are of multipart construction, each comprising a stamp pin which is identical for all stamps and which cooperates with the driving elements, and an exchangeable attachment which is mounted on the upper end of the stamp pin and which comprises the stamp head.

Due to the exchangeability of the attachment, each stamp can be provided in a simple manner with an attachment whose stamp head has a shape which corresponds to that of the component supplied to the relevant stamp position to be provided with a fixing medium. The stamp head is shaped so that the fixing medium is applied in an optimum quantity for this component and in a form specific for this component. To components having a comparatively small base surface a smaller quanity of the fixing medium is applied than to components having a larger base surface: heavier components require a larger quantity of the fixing medium than lighter components. The fixing medium can be applied in the form of an elongate drop to components having an elongate base surface. The overall quanity of fixing medium to be applied can be applied in a single large drop or in several small drops, depending upon the dimensions of the base surface of the component. Moreover, the track pattern on the substrate on which the components will be ultimately mounted can be taken into account as well: the fixing medium is applied to the component in such a manner that the possibility of contamination of the track pattern on the substrate is a minimum.

By changing the attachments the device can be reassembled and adapted simply and rapidly to various products, that is to say to different series of components to be arranged and to various substrates to be provided with components.

It should be noted that glue, a glue component, an activator, soldering paste and the like may be used as a fixing medium.

A preferred embodiment of the invention is characterized in that the bottom of the trough is provided with bores in which the stamp pins are slidable and in that the trough is closed at the upper side by a cover plate which is provided with holes arranged one in line with each stamp.

As described in the aforementioned European Patent Application EP—A—0 071 303, the components to be placed on a substrate are picked up, transported and placed by means of pick-up devices. In order to apply a fixing medium to the lower sides of the components, the pick-up devices with the components are halted over a container which is open at the upper side. The stamps are displaced upwards from their rest positions into their working positions, each stamp taking with it a quantity of the fixing medium surrounding the stamp head in the form of a cone and depositing a part of this fixing medium on the lower side of the respective component. The stamps finally return to their rest positions.

When the upper side of the trough is closed by a cover plate provided with holes, as in the above embodiment of the invention, the component can be arranged by the pick-up devices on the cover plate and can be pressed against the cover plate. All the components are located with their lower sides in the same horizontal plane, i.e. the upper surface of the cover plate, which serves as a reference plane. When the cover plate is used as a reference element, the reproducibility of the process of applying a fixing medium is increased. The transverse dimensions of the holes in the cover plate are identical and generally larger than the cross-section of the thickest stamp head. At any rate, the holes in the cover plate are so dimensioned that all the stamps with their stamp heads and the fixing medium adhering thereto can pass through them and that contamination and clogging with fixing medium are avoided; however, the holes must not be so large that the components are not adequately supported by the cover plate.

In a further embodiment of the invention, exchangeable supporting plates for supporting electronic components are provided on the cover plate so as to extend over the holes in the cover plate, the supporting plates being identical in shape and size and each being provided with at least one aperture having a shape and dimensions such that the stamp head of an associated one of the stamps can pass through it, and the cover plate and the supporting plates being provided with guides and positioning means for positioning the supporting plates with respect to the stamps.

When the device is provided with exchangeable supporting plates for supporting the components, an individual supporting plate can be arranged in the relevant position for each type of component with an aperture suited specifically for this component. The aperture in the supporting plate is dimensioned and profiled so that on the one hand the component is supported sufficiently and cannot drop through the opening, whereas on the other hand the opening has to be sufficiently large to allow the fixing medium on the stamp head of the relevant stamp to reach the lower side of the component, while the aperture also has to remain free from fixing medium. The provision of the specific apertures in the supporting plates offers in addition the possibility of sufficiently supporting very small components during the application of a fixing medium.

The high degree of flexibility of the device obtained already by the above provisions is further increased by the exchangeability of the supporting plates, as a result of which it is possible to arrange the most suitable supporting plate for the relevant component in every stamp position. The changing of the supporting plates will generally be associated with the changing of the attachments of the stamps.

A further increase of the flexibility is obtained in a further embodiment of the invention which is characterized in that each supporting plate is provided with several apertures having different shapes and dimensions and can be selectively moved to and positioned in any of a corresponding number of positions. In order to prepare the device for another series of components, the supporting plates need only be individually adjusted to another position, at least as far as the most frequently used components are concerned. When each supporting plate is provided with several apertures, the number of supporting plates to be stored is restricted.

In a further embodiment of the invention the cover plate is provided with magnet elements for holding the supporting plates in the selected positions. This enables the readjustment and changing of the supporting plates to be carried out very rapidly and efficiently.

With the above measures, a device for applying a fixing medium to electronic components, more particularly chip-type components, is obtained which is universal, that is to say that it is suitable for processing a wide range of chip-type components of different shapes and dimensions, which device is moreover very flexible and by virtue of the exchangeability of various elements can be readjusted and adapted in a simple and efficient manner.

The invention will be described more fully with reference to the drawings. In the drawings:

Fig. 1 shows in front elevation an embodiment of the device according to the invention,

Fig. 2 shows the device in cross-section taken on the line II—II in fig. 1,

Fig. 3 is a longitudinal sectional view of the device taken on the line III—III in fig. 1,

Fig. 4 is a cross-section view of part of the device drawn to an enlarged scale,

Fig. 5 is an longitudinal sectional view of part of the device taken on the line V—V in fig. 4,

Fig. 6 is a sectional view taken on the line VI—VI in fig. 4.

Fig. 7 is a plan view of the part of the device shown in figures 4 and 5.

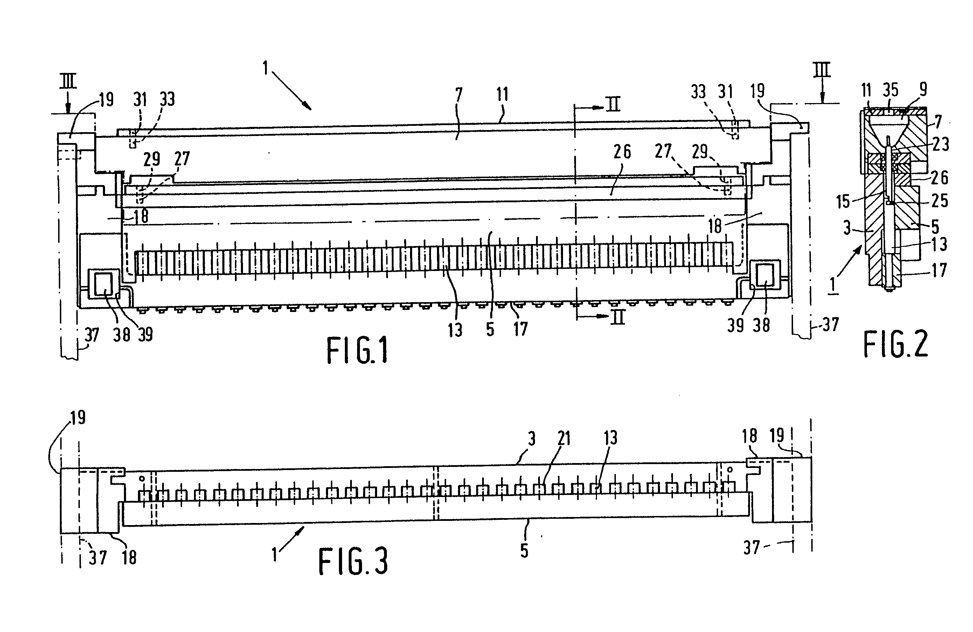

First the general construction of the device will be described with reference to figures 1 to 3. The device 1 mainly comprises an elongate supporting block 3, an elongate closure block 5, a trough 7 closed at the upper side by a cover plate 11, a number of push rods 13 with stamps 15, a driving beam 17 and side flange 18 with suspension flanges 19. Grooves 21 are provided in the supporting block 3 at regular intervals along the block. The grooves are closed over part of their length by the closure block 5 and serve to guide the push rods 13. The grooves 21 and the push rods have a square cross-section so that the push rods are locked against rotation. The push rods 13 are connected at their lower ends to the common driving beam 17, which is displaceable vertically relative to the supporting block 3 and the closure block 5. The trough 7 is supported by the supporting block 3 and the closure block 5 and is positioned with respect to these parts by means of positioning pins 27 on the supporting block 3 which cooperate with positioning holes 29 in the trough 7. The bottom of the trough 7 is provided with bores 23 which serve to guide tha stamps 15, which are coupled to the push rods 13 by means of hooked connections 25 in a detachable manner and in a manner such that the stamps 15 are locked against rotation. Reference numeral 26 denotes a covering strip which can be removed so that in the working position of the stamps 15 the hook connections 25 are accessible and the stamps 15 can be uncoupled from the push rods 13. The cover plate 11 is positioned with respect to the trough by means of positioning holes 31 cooperating with positioning pins 33 on the trough 7. The cover plate 11 is provided with a series of holes 35 arranged one in line with each stamp. By means of the suspension flanges 19, the device can be mounted in a frame 37 shown in dot-dash lines, for example the frame of a device as described in the aforementioned European Patent Application. From a drive not shown the driving beam 17 is driven up and down in a reciprocatory manner by means of rollers 38 which cooperate with recesses 39 in the driving beam.

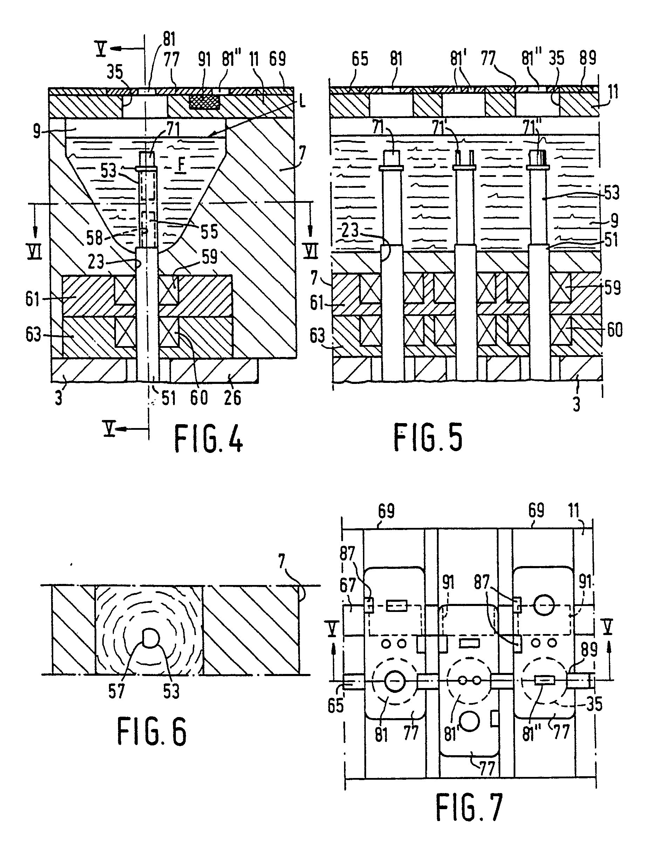

A number of essential elements will now be described more fully with reference to figures 4 to 7. The stamps 17 are of two-part construction, each comprise a stamp pin 51 which is identical for all stamps and has a circular cross-section, and which is detachably coupled by means of the respective hooked connection 25 to the relevant push rod 13, and an exchangeable attachment 53 comprising a circular-cylindrical sleeve, which is secured in a detachable manner, for example with a push fit, on an end portion 55 of the stamp 51. By providing the attachment 53 and the end portion 55 with mating flats 57 and 58, respectively, a form of connection is established between these two parts such that the attachment 53 is also locked against rotation. The attachment 53 can be exchanged without removing the trough 7; only the cover plae 11 has to be removed. The trough 7 is filled to the level L with a viscous fixing means F. The pin 51 of each stamp 15 is surrounded by two coaxially spaced annular seals 59 and 60. The seals 59 are mounted in holder 61 during which is attached to the trough 7, while the seals 60 are mounted in a holder 63 which is attached to the supporting block 3. The seals 59 prevent fixing medium leaking away down the surfaces of the stamps.

The trough 7 can be removed from the device, for example for periodical cleaning, without the necessity of removing the stamps 15. This is possible due to the fact that the maximum transverse dimension of the attachments 53 is no greater than the maximum diameter of the stamp pins 51 so that the seals 59 can pass over the attachments 53 when the trough 7 is lifted off.

The seals 60 protect the driving mechanism from any leaking fixing medium when the trough 7 has been removed.

Each attachment 53 has at its upper end a stamp head which has a given shape and corresponds specifically to a given electronic component; for example, a stamp head 71 having a circular-cylindrical profile, a stamp head 71' comprising two cylindrical pins, a stamp head 71" having a rectangular profile, and the like.

The holes 35 in the cover plate 11 have a diameter which is larger than the maximum transverse dimension of the attachments 53. The cover plate 11 is provided in its upper side with a narrow longitudinal groove 65, with a wider longitudinal groove 67 and which transverse grooves 69 located one above each stamp. A supporting plate 77 for supporting an electronic component is slidably arranged in each transverse groove 69. The supporting plates all have identical peripheries and they are each formed with a number of different apertures, in the embodiment shown, each plate has a circular aperture 81, two small cylindrical apertures 81' and a rectangular aperture 81". In the outer periphery of each supporting plate 77 are recesses 87 located one beside the aperture 81 in the plate, one beside the two small apertures 81' and one beside the aperture 82". The recesses 87 are cooperable with locating pegs 89 which are secured, for example by means of glue, in the narrow longitudinal groove 65 and project into the transverse grooves 69. These recesses and locating pegs serve for the correct positioning of the supporting plates 77 in such a manner that a selected one of the apertures in each plate is located in line with the relevant stamp 15, whose stamp head has a profile corresponding to the profile of the selected aperture in the supporting plate. Thus, in the present instance, the stamp with the circular-cyindrical stamp head 71 is cooperable with the circular aperture 81 in the supporting plate 77; the stamp head 71' having two pins in cooperable with the cylindrical apertures 81' and the rectangular stamp head 71" is cooperable with the rectangular aperture 81". The apertures 81, 81' and 81" are each so proportioned that the relevant stamp head substantially reaches the lower side of a component bearing on the respective supporting plate, whereby the fixing medium surrounding the stamp head in the form of a cone comes into contact with the component without the wall of the aperture coming into contact with the fixing medium.

At regular intervals along the wide longitudinal groove 67, small plate-shaped magnets 91 and secured in this groove, for example by means of glue.

These magnets 91 are located one beneath each supporting plate 77 and serve to hold the supporting plates 77 in the selected positions in the transverse gooves 69. Each plage can be slid from one position to another in the respective groove 69 or can be exchanged with another plate in a simple manner.

For applying a quantity of the fixing medium F to a number of chip-type components, the components, supplied in one row, are arranged one on each of the supporting plates 77. The stamp heads and the supporting plates have been previously selected and arranged in such a manner that at each stamp position a stamp head corresponding to the relevant component is directly below a corresponding aperture in the respective supporting plate, which is also intended specifically for this component. The components are now all supported with their lower sides in the same plane. Subsequently, the stamps 15 are moved simultaneously upwards by means of the driving beam 17, and *via* the push rods 13, from the rest position shown in fig. 4, in which the stamp heads are immersed completely in the fixing medium F in the trough 7, to a working position in which the stamp heads are located with their upper sides immediately below and near the lower sides of the components, and a quantity of fixing medium carried up on each stamp is transferred from the upper side of the stamp head to the lower side of the respective component. The stamps are then returned downwards to the rest position. The components thus provided with fixing medium are lifted off the supporting plates and transported further.

The internal cross-section of the trough 7 decreases in width towards the bottom, as a result of which on the one hand the required quantity of fixing medium in the trough up to the average level L remains limited, whereas on the other hand an excessively rapid fall of the level is avoided.

## Claims

1. A device for applying a fixing medium to electronic components, more particularly to chip-type components, comprising a trough for containing fixing medium and plurality of stamps with stamp heads which are directed vertically upwards and which stamps are arranged in a regular geometric pattern, the stamps being coupled at their lower ends to a common driving element and each being displaceable in a vertical direction between a lower rest position in which the respective stamp head is situated wholly within the trough and an upper working position in which the stamp head projects above the trough, characterized in that the stamps are of multipart construction, each comprising a stamp pin which is identical for all stamps and which cooperates with the driving element, and an exchangeable attachment which is mounted on the upper end of the stamp pin and which comprises the stamp head.

2. A device as claimed in Claim 1, characterized in that the bottom of the trough is provided with bores in which the stamp pins are slidable and in that the trough is closed at the upper side by a cover plate which is provided with holes arranged one in line with each stamp.

3. A device as claimed in Claim 2, characterized in that exchangeable supporting plates for supporting electronic components are provided on the cover plate so as to extend over the holes in the cover plate, the supporting plates being identical in shape and size and each being provided with at least one aperture having a shape and dimensions such that the stamp head of an associated one of the stamps can pass through it, and the cover plate and the supporting plates being provided with guides and positioning means for positioning the supporting plates with respect to the stamps.

4. A device as claimed in Claim 3, characterized in that each of the supporting plates is provided with several apertures having different shapes and dimensions and can be selectively moved to and positioned in any of a corresponding number of positions.

5. A device as claimed in Claim 3 or 4, characterized in that the cover plate is provided with magnet elements for holding the supporting plates in the selected positions.

## Patentansprüche

1. Vorrichtung zum Auftragen eines Befestigungsmittels auf elektronische Bauteile, insbesondere auf chipförmige Bauteile mit einem Behälter für Befestigungsmittel und einer Anzahl Stempel mit Stempelköpfen, die vertikal aufwärts gerichtet sind und in einem regelmässigen geometrischen Muster angeordnet sind, wobei die unteren Enden der Stempel mit einem gemeinsamen Antriebselement gekuppelt sind und wobei jeder Stempel zwischen einer unteren Ruhelage, in der der betreffende Stempelkopf völlig in dem Behälter liegt, und einer oberen Arbeitslage, in der Stempelkopf über den Behälter hinausragt, in vertikaler Richtung beweglich ist, dadurch gekennzeichnet, dass die Stempel mehrteilig ausgebildet sind und je einen allen Stempeln identischen Stempelstift aufweisen, der mit dem Antriebselement zusammenarbeitet, sowie einen austauschbaren Aufsatz für den Stempelkopf, der auf der Oberseite des Stempelstiftes angeordnet ist.

2. Vorrichtung nach Anspruch 1, dadurch gekennzeichnet, dass in dem Boden des Behälters Bohrungen vorgesehen sind, in denen die Stempelelemente verschiebbar sind und dass der Behälter an der Oberseite durch eine Abdeckplette mit Löchern, eins fluchtend zu jedem Stempel, abgeschlossen ist.

3. Vorrichtung nach Anspruch 2, dadurch gekennzeichnet, dass auf der Abdeckplatte auswechselbare Unterstützungsplatten vorgesehen sind, deren Form und Abmessungen einander entsprechen und welche die Löcher in der Abdeckplatte wenigstens teilweise überlappen, wobei diese Unterstüutzungsplatten mit mindestens einer Öffnung einer derartigen Form und Grösse versehen sind, dass der Stempelkopf des betreffenden Stempels hindurchgehen kann, wobei die Abdeckplatte und die Unterstützungsplatten mit Führungen und Ausrichtmitteln zum Ausrichten der Unterstützungsplatten gegenüber den Stempeln vershen sind.

4. Vorrichtung nach Anspruch 3, dadurch gekennzeichnet, dass jede Unterstützungsplatte mit mehreren Öffnungen unterschliedlicher Formen und Abmessungen versehen ist und wahlweise in jeder einer entsprechenden Anzahl Lagen verschiebbar ist und darin ausgerichtet werden kann.

5. Vorrichtung nach Anspruch 3 oder 4, dadurch gekennzeichnet, dass zum Festhalten der Unterstützungsplatten in den gewählten Lagen die Abdeckplatte mit Magnetelementen versehen ist.

**Revendications**

1. Dispositif pour appliquer un agent de fixation sur des composants électroniques, notamment des composants dits microcomposants, comportant, d'une part, un bac allongé servant à contenir un agent de fixation et, d'autre, part, une pluralité de tampons présentant des têtes dirigées verticalement vers le haut, tampons qui sont arrangés suivant une configuration géometrique régulière, les tampons étant couplés à leur extrémités inférieures à élément d'entraînement commun et pouvant être déplacés chacun dans une direction verticale, entre une position inférieure de repos dans laquelle la tête de tampon est située entièrement dans le bac, et une position supérieure de fonctionnement dans laquelle la tête de tampon dépasse du bac, caractérisé en ce que les tampons sont constitués par plusieurs parties en comportant chacun une broche identique pour tous les tampons et coopérant avec les éléments d'entraînement, et une pièce rapportée échangeable montée à l'extrémité supérieure de la broche de tampon et comportant la tête de tampon.

2. Dispositif selon la revendication 1, caractérisé en ce que le fond du back présente des alésages dans lesquels peuvent glisser les broches de tampon et en ce que le bac est fermé en haut par une plaque de recouvrement présentant des trous qui sont alignés chacun par rapport à un tampon.

3. Dispositif selon la revendication 2, caractérisé en ce que des plaques de support échangeables servant à supporter les composants électroniques sont prévues sur la plaque de recouvrement de façon à s'étendre au-dessus des trous pratiqués dans la plaque de recouvrement, les plaques de support ayant toutes la même forme et la même taille, alors qu'elles présentent chacune au moins une ouverture de forme et de dimensions telles que le tête d'un tampon associé peut passer par celle-ci, la plaque de recouvrement et les plaques de support étant munies de guides et de moyens de positionnement pour positionner les plaques de support par rapport aux tampons.

4. Dispositif selon la revendication 3, caractérisé en ce que les plaques de support présentent chacune plusieurs ouvertures ayant des formes et des dimensions différentes et en ce qu'elles peuvent être amenées et positionnées de façon sélective dans un nombre correspondant de positions.

5. Dispositif selon la revendication 3 ou 4, caractérisé en ce que la plaque de recouvrement est munie d'éléments aimantés pour maintenir les plaques de support dans les positions choisies.

FIG.2

FIG.1

FIG.3

FIG.4

FIG.5

FIG.6

FIG.7